(19) **Europäisches Patentamt**

**European Patent Office**

**Office européen des brevets**

(11) **EP 1 115 000 B1**

(12) **EUROPÄISCHE PATENTSCHRIFT**

(45) Veröffentlichungstag und Bekanntmachung des Hinweises auf die Patenterteilung:
**27.12.2006 Patentblatt 2006/52**

(51) Int Cl.:
***G01R 15/24*** *(2006.01)*

(21) Anmeldenummer: **00811132.0**

(22) Anmeldetag: **28.11.2000**

(54) **Faseroptischer Stromsensor**

Fibre optic current sensor

Capteur de courant à fibre optique

(84) Benannte Vertragsstaaten:
**AT BE CH CY DE DK ES FI FR GB GR IE IT LI LU MC NL PT SE TR**

(30) Priorität: **05.01.2000 DE 10000306**

(43) Veröffentlichungstag der Anmeldung:
**11.07.2001 Patentblatt 2001/28**

(73) Patentinhaber: **ABB RESEARCH LTD.**
**8050 Zürich (CH)**

(72) Erfinder:
• **Bohnert, Klaus**
**5452 Oberrohrdorf (CH)**
• **Nehring, Jürgen**
**5430 Wettingen (CH)**

(74) Vertreter: **ABB Patent Attorneys**
**c/o ABB Schweiz AG**
**Brown Boveri Strasse 6**
**5400 Baden (CH)**

(56) Entgegenhaltungen:
**EP-A- 0 856 737       DE-A- 19 506 169**
**US-A- 5 780 847**

• **BLAKE J ET AL: "IN-LINE SAGNAC INTERFEROMETER CURRENT SENSOR" IEEE TRANSACTIONS ON POWER DELIVERY, IEEE INC. NEW YORK, US, Bd. 11, Nr. 1, 1996, Seiten 116-121, XP000554185 ISSN: 0885-8977**
• **PATENT ABSTRACTS OF JAPAN vol. 005, no. 185 (P-091), 25. November 1981 (1981-11-25) & JP 56 112657 A (MATSUSHITA ELECTRIC IND CO LTD), 5. September 1981 (1981-09-05)**

**Beschreibung**

**Technisches Gebiet**

Die vorliegende Erfindung betrifft einen faseroptischen Stromsensor gemäss Oberbegriff des Patentanspruches 1.

**Stand der Technik**

Ein gattungsgemässer faseroptischer Stromsensor ist aus EP-A-0'856'737 bekannt. Er weist eine spulenförmig gewickelte, magnetooptisch aktive Sensorfaser auf, welche einen Stromleiter umschliesst. Mindestens an einem Ende ist die Sensorfaser über ein Phasenverzögerungselement mit einer weiteren optischen Faser, einer sogenannten Zu- beziehungsweise Rückleitungsfaser, verbunden, über welche sich Licht in die Sensorfaser ein- beziehungsweise auskoppeln lässt. Die Sensorfaser ist typischerweise aus Quarzglas gefertigt und weist einen runden Kernquerschnitt auf. In der Sensorfaser propagiert zirkular polarisiertes Licht. Die Zu- beziehungsweise Rückleitungsfasern haben vorzugsweise einen elliptischen Kernquerschnitt und propagieren linear polarisiertes Licht. Als Phasenverzögerungselement wirkt ein doppelbrechendes Fasersegment, welches zwischen Sensorfaser und Zuleitungsfaser angeordnet ist. Das Fasersegment weist optische Hauptachsen auf, welche unter 45° zu den Hauptachsen der Zu- beziehungsweise Rückleitungsfasern ausgerichtet sind. Üblicherweise ist seine Länge so gewählt, dass es als $\lambda/4$-Phasenverzögerungselement wirkt. Dadurch wandelt es linear polarisiertes Licht der Zu- und Rückleitungsfasern in zirkular polarisiertes Licht um, welches sich in der Sensorfaser ausbreitet.

Die Sensorfaser wird entweder als Sagnac-Interferometer oder, wenn eines ihrer Enden verspiegelt ist, als Reflexions-Interferometer betrieben. In beiden Fällen breiten sich in der Sensorfaser zwei zirkular polarisierte optischen Wellen aus. Die Wellen sind dabei im Falle des Sagnac-Interferometers gegenläufig, im Falle des Reflexions-Interferometers laufen sie in gleicher Richtung. Im Sagnac-Interferometer haben beide Wellen denselben Polarisationssinn, wobei sie entweder links oder rechts zirkular polarisiert sind. Im Reflexions-Interferometer weisen sie einen entgegengesetzten Polarisationssinn auf.

Ist der Stromleiter stromdurchflossen, so erzeugt der Strom ein magnetisches Feld, welches zu einer differentiellen Phasenverschiebung zwischen diesen zwei gegenläufigen bzw. gleichlaufenden optischen Wellen führt. Dieser Effekt wird magneto-optischer oder Farraday-Effekt genannt. Die entstandene Phasenverschiebung ist dabei proportional zum Strom und beträgt in der Sagnac-Konfiguration

$$\Delta \Phi_S = 2\,V\,N\,I \qquad\qquad (1)$$

und in der Reflexionskonfiguration

$$\Delta \Phi_R = 4\,V\,N\,I \qquad\qquad (2),$$

wobei V die Verdet-Konstante der Faser, N die Anzahl der Faserwindungen in der Spule und I die Stromstärke bezeichnet.

Die in EP-A-0'856'737 beschriebene Sensorfaser ist zwar frei von mechanischen Spannungen, so dass das erhaltene Sensorsignal nicht von einer temperatur-abhängigen, stress-induzierten linearen Doppelbrechung gestört wird. Die Verdet-Konstante V weist jedoch ebenfalls eine Temperaturabhängigkeit auf, welche selbst bei einer idealen, stress-freien Faserspule bemerkbar ist. So beträgt die Temperaturabhängigkeit im Falle einer Quarzfaser pro °C circa $0.7 \times 10^{-4}$. Das Sensorsignal verändert sich somit bei einer Temperaturschwankung von 100°C um 0.7%. Für Anwendungen des Stromsensor in Höchspannungsanlagen ist aber oft eine wesentlich grössere Genauigkeit der Stromessung gefordert. Typische Werte liegen bei $\pm 0.2\%$ in einem Temperaturbereich von -40° C bis +85°C.

Die Erfindung, nimmt auf das U. S. Pat. No. 5,780,847 Bezug. Dort wird ein faseroptischer Stromsensor mit reduzierter Temperaturempfindlichkeit offenbart. Der Stromsensor wird polarimetrisch betrieben derart, dass in der Sensorspule eine lineare Lichtpolarisation geführt und durch strominduzierten Faradayeffekt gedreht wird. Die . Verdetkonstante und damit der Faraday-Drehwinkel des linearen Polarisationsvektors sind temperaturabhängig. Der Relativwinkel von $\pm 45°$ zwischen Polarisator vor der Sensorspule und Analysator nach der Sensorspule weist, bedingt durch die Fasermontage und Verpackung, eine zusätzliche Temperaturabhängigkeit auf, welche sich für eine erste Analysatororientierung gleichsinnig und für eine zweite, dazu orthogonale Analysatororientierung gegensinnig zur Temperaturabhängigkeit des Faradayeffekts verhält. Durch Wahl der zweiten Analysatororientierung kann ein weitgehend temperaturunabhängiges polarimetrisches Faradayeffekt-Stromsensorsignal gewonnen werden.

In der DE 195 06 169 A1 wird ein massivoptischer, ebenfalls polarimetrisch betriebener Stromsensor mit reduzierter Temperaturempfindlichkeit offenbart.

In diesem Fall werden Temperatureinflüsse durch lineare Doppelbrechung und Verdetkonstante in der Sensoreinrichtung dadurch kompensiert, dass die Polarisatonsachsen von Polarisator und Analysator unter einem vorgebbaren Winkel relativ zur Hauptachse der linearen Doppelbrechung in der Sensoreinrichtung eingestellt werden.

In dem JP-A-56112657 ist eine massivoptische, wiederum polarimetrischbetriebene Strommesseinrichtung mit temperaturkompensiertem Faradayeffekt offenbart. Die Strommesseinrichtung umfasst einen Polarisator, ein plattenförmiges Faradayelement, nachgeschaltet eine linear doppelbrechende Temperaturkompensationsplatte und einen Analysator. Die Temperaturkompensationsplatte weist eine Hauptachse auf, die parallel zum Polarisator orientiert ist. Der Analysator ist um 45° verdreht zum Polarisator bzw. zur Hauptachse der Temperaturkompensationsplatte ausgerichtet. Eine temperaturbedingte Änderung des Faraday-Drehwinkels führt dazu, dass, der Faradaygedrehte Polarisationsvektor unter einem Winkel zur Hauptachse auf die Temperaturkompensationsplatte einfällt und elliptisch wird. Durch eine geeignete Wahl der Temperaturabhängigkeit der Grösse der linearen Doppelbrechung der Temperaturkompensationsplatte kann die Temperaturabhängigkeit des Faraday-Drehwinkels kompensiert werden.

## Darstellung der Erfindung

Es ist deshalb Aufgabe der Erfindung, für einen faseroptischen, interferometrisch betriebenen Stromsensor eine neuartige Temperaturkompensation anzugeben.

Diese Aufgabe löst ein Stromsensor mit den Merkmalen des Patentanspruches 1.

Erfindungsgemäss verfügt der Stromsensor über mindestens ein Phasenverzögerungselement mit einer Temperaturabhängigkeit, welche eine Temperaturabhängigkeit einer Verdet-Konstanten einer Sensorfaser mindestens annähernd kompensiert.

Die Kompensation erfolgt, indem das Phasenverzögerungselement einen entsprechenden Phasenverzögerungswinkel aufweist, welcher von einem Phasenverzögerungswinkel eines idealen Phasenverzögerungselementes abweicht. Dabei wird er in Abhängigkeit eines Vorzeichens seiner Temperaturabhängigkeit grösser oder kleiner gewählt als derjenige des idealen Phasenverzögerungselementes, beispielsweise als ein 90°-Phasenverzögerungswinkel eines idealen $\lambda/4$-Segmentes.

Im Falle eines Sagnac-Interferometers ist der Phasenverzögerungswinkel zudem in Abhängigkeit einer relativen Ausrichtung von schnellen Achsen des Phasenverzögerungselementes zueinander gewählt.

Vorzugsweise ist das Phasenverzögerungselement ein doppelbrechendes Fasersegment mit einem elliptischen Kernquerschnitt, wobei durch Wahl der Länge des Segmentes der Phasenverzögerungswinkel einstellbar ist.

Weitere vorteilhafte Ausführungsformen gehen aus den abhängigen Patentansprüchen hervor.

## Kurze Beschreibung der Zeichnungen

Im folgenden wird der Erfindungsgegenstand anhand von bevorzugten Ausführungsbeispielen, welche in den beiliegenden Zeichnungen dargestellt sind, näher erläutert. Es zeigen:

Figur 1    eine schematische Darstellung eines faseroptischen Stromsensors in Form eines Sagnac-Interferometers;

Figur 2    eine graphische Darstellung eines normierten Skalenfaktors in Funktion der Temperatur;

Figur 3    eine graphische Darstellung eines normierten Skalenfaktors des Sensors gemäss Figur 1 als Funktion einer Abweichung $\delta$ einer Phasenverzögerung von einem 90°-Phasenverzögerungswinkel eines idealen $\lambda/4$-Segmentes und

Figur 4    eine schematische Darstellung eines faseroptischen Stromsensors in einer Reflexionskonfiguration.

## Wege zur Ausführung der Erfindung

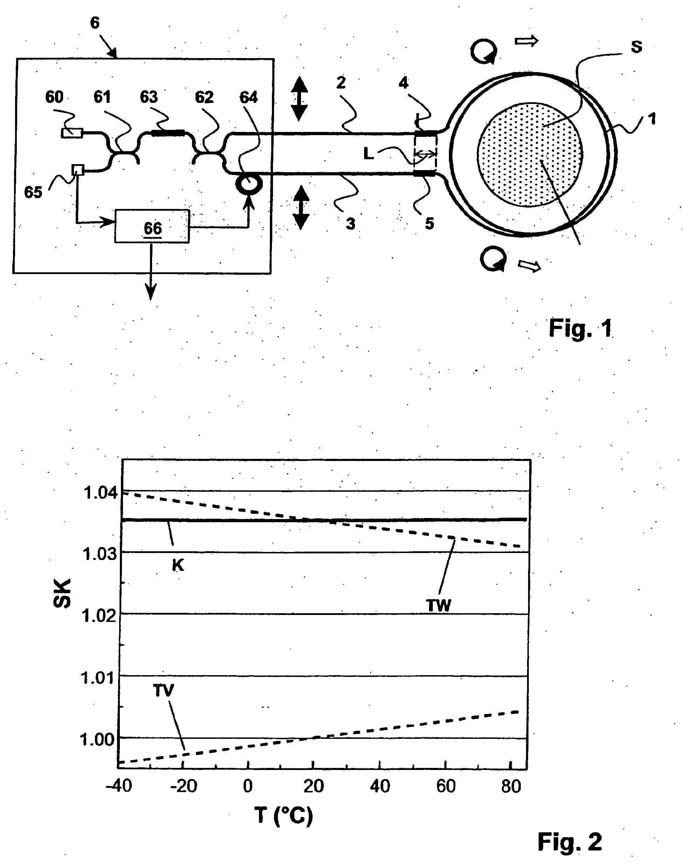

Figur 1 zeigt einen faseroptischen Stromsensor in einer Sagnac-Konfiguration. Sein grundsätzlicher Aufbau und seine Wirkungsweise sind aus dem eingangs zitierten Stand der Technik bekannt. Es wird im folgenden nicht detailliert darauf eingegangen.

Eine Sensorfaser 1 mit einem runden Kernquerschnitt ist spulenförmig um einen Stromleiter S gewickelt. Ein erstes Ende der Sensorfaser 1 ist mit einer Zuleitungsfaser 2, ein zweites Ende mit einer Rückleitungsfaser 3 verbunden. Zuleitungs- und Rückleitungsfasern 2,3 weisen vorzugsweise einen elliptischen Kernquerschnitt auf. Die Verbindung von Zu- beziehungsweise Rückleitungsfaser 2,3 mit der Sensorfaser 1 erfolgt über mindestens je ein, hier genau ein Phasenverzögerungselement 4,5.

Im hier dargestellten Beispiel sind die Phasenverzögerungselemente 4,5 kurze Segmente einer doppelbrechenden Faser, vorzugsweise mit einem elliptischen Kern. Dabei weist die Faser optische Hauptachsen der Doppelbrechung auf, welche mit den Hauptachsen des elliptischen Kerns zusammenfallen. Der Kern weist somit eine lange und eine kurze Hauptachse auf, wobei die kurze Hauptachse schnelle Achse genannt wird.

Die Zu- und Rückleitungsfasern 2,3 sind so mit den Phasenverzögerungselementen 4,5 zusammengefügt, dass die kurzen Hauptachsen der Faserkerne der beiden Fasern einen definierten Auslenkungswinkel, vorzugsweise von 45°, bilden. Die lineare Polarisation in der Zuleitungsfaser, welche entweder parallel zur langen oder zur kurzen Kernachse ausgerichtet ist, spaltet sich beim Eintritt in das Phasenverzögerungselement in zwei orthogonale Polarisationskomponenten auf, welche parallel zu den Hauptachsen des Kerns des Phasenverzögerungselementes gerichtet sind. Die beiden Polarisationskomponenten breiten sich aufgrund der Doppelbrechung mit unterschiedlicher Geschwindigkeit aus, wobei die Ausbreitungsgeschwindigkeit der zur schnellen Achse parallelen Komponenten grösser ist als die andere. Am Ende des Phasenverzögerungselementes haben die zwei Polarisationskomponenten eine differentielle Phasenverzögerung akkumuliert, die sich durch einen Phasenverzögerungswinkel $\varphi$ beschreiben lässt. Der Phasenverzögerungswinkel $\varphi$ wächst proportional mit der Länge des Phasenverzögerungselementes. Bei einem idealen $\lambda/4$-Segment nullter Ordnung entspricht die differentielle Verzögerung einem Viertel der Wellenlänge und der Phasenverzögerungswinkel $\varphi$ beträgt 90°. Das aus dem Phasenverzögerungselement austretende Licht ist dann zirkular polarisiert. Bei einem $\lambda/4$-Segment höherer Ordnung entspricht der Phasenverzögerungswinkel einem ungeradzahligen Vielfachen von 90°.

Zu- und Rückleitungsfaser 2,3 sind mit einem ebenfalls bekannten gyroskopischen Modul 6 verbunden. Das gyroskopische Modul 6 weist eine Lichtquelle, insbesondere eine Laserdiode 60, zwei Faserkoppler 61,62, einen Faserpolarisator 63, einen Phasenmodulator 64, eine Photodiode 65 und einen Signalprozessor 66 auf. Eine in der Laserdiode 60 erzeugte optische Welle gelangt über den ersten Faserkoppler 61 in den Faserpolarisator 63, wird linear polarisiert und anschliessend im zweiten Faserkoppler 62 in zwei Teilwellen zerlegt. Die erste, nach wie vor linear polarisierte Teilwelle gelangt über die Zuleitungsfaser 2 zum ersten Phasenverzögerungselement 4, wird in zirkular polarisiertes Licht gewandelt und in die Sensorfaser 1 eingekoppelt. Anschliessend gelangt sie über das zweite Phasenverzögerungselement 5, wo sie wieder in linear polarisiertes Licht gewandelt wird, weiter über die Rückleitungsfaser 3 und den Phasenmodulator 64 zum zweiten Phasenkoppler 62 zurück. Die zweite Teilwelle durchläuft das Interferometer in entgegengesetzter Richtung. Propagationsrichtung und Polarisationen der zwei Teilwellen sind in Figur 1 mit Pfeilen dargestellt.

In der Sensorfaser 1 breiten sich somit zwei gegenläufige optische Wellen aus. Ist der Stromleiter S stromdurchflossen, so erfahren diese zwei Wellen die eingangs erwähnte zum Strom proportionale differentielle Phasenverschiebung $\Delta\Phi_s$.

Erfindungsgemäss wird nun die Temperaturabhängigkeit der Phasenverzögerung in den Phasenverzögerungselementen 4,5 ausgenützt, um die Temperaturabhängigkeit der Verdet-Konstanten V mindestens annähernd zu kompensieren. Eine derartige Kompensation ist in Figur 2 dargestellt, wobei eine Sensitivität des Sensors, normierter Skalenfaktor SK genannt, in Abhängigkeit der Temperatur dargestellt ist. Durch Wahl eines geeigneten Phasenverzögerungswinkels wurde ein nahezu temperaturunabhängiger Skalenfaktor erzielt, was in der Funktion K(T) dargestellt ist. Die Funktion K(T) ist das Produkt der Funktionen TW(T) und TV(T). Dabei zeigt TV(T), wie sich der Skalenfaktor SK aufgrund der Temperaturabhängigkeit der Verdet-Konstanten verändert. TW(T) beschreibt die Änderung des Skalenfaktors SK aufgrund der temperaturabhängigen Phasenverzögerung in den Phasenverzögerungselementen 4,5. Erfindungsgemäss wird deshalb die Temperaturabhängigkeit von TW(T) so gewählt, dass sie diejenige von TV(T) mindestens annähernd kompensiert. Als Nebeneffekt erhöht oder vermindert sich dabei der normierte Skalenfaktor SK.

Bei einem faseroptischen Phasenverzögerungselement lässt sich der gewünschte Phasenverzögerungswinkel durch Wahl der Länge L des Fasersegmentes erreichen. Ein ideales $\lambda/4$-Segment nullter Ordnung weist einen Phasenverzögerungswinkel von 90° auf, wobei hierfür die ideale Länge des Segmentes ein Viertel einer Schwebungslänge von orthogonalen Polarisationsmoden beträgt. Bei einem $\lambda/n$-Segment der Ordnung m beträgt die ideale Länge ein m-Vielfaches von 1/n. Bei einem erfindungsgemäss temperaturkompensierten Phasenverzögerungselement weicht dessen Länge L von dieser idealen Länge ab. Welcher Phasenverzögerungswinkel bzw. welche Länge L jedoch zur Temperaturkompensation geeignet sind, erschliesst sich aus folgenden Überlegungen:

Die Ausbreitung der optischen Wellen durch die verschiedenen faseroptischen Teile des Stromsensors lässt sich mittels der Jones-Matrizen beschreiben. Ist die Phasenverzögerung in den beiden $\lambda/4$-Phasenverzögerungselementen genau 90°, das heisst, sind die beiden gegenläufigen Wellen exakt zirkular polarisiert, so ist bei einer idealen, temperatur unabhängigen Faserspule die strominduzierte differentielle Phasenverschiebung zwischen den zwei Wellen durch Gleichung (1) gegeben. Weicht die Phasenverzögerung in den beiden Phasenverschiebungselementen von diesem idealen Phasenverzögerungswinkel von 90° ab, so beträgt die strom-induzierte Phasenverschiebung

$$\Delta\Phi'_S = 2\ \arctan\ [\tan\ (\Delta\Phi_S/2)\ \cos(\delta_1/2 + \delta_2/2)\ /\ \cos(\delta_1/2 - \delta_2/2)] \qquad (3)$$

$\Delta\Phi_S$ ist dabei durch Gleichung (1) gegeben. $\delta_1$ und $\delta_2$ betreffen die Abweichung der differentiellen Phasenverzögerungen $\varphi_1$, und $\varphi_2$ in den beiden Phasenverzögerungseleinenten.

$$\delta_1 = \varphi_1 - 90° \qquad (4)$$

$$\delta_2 = \varphi_2 - 90° \qquad (5).$$

Gleichung (3) gilt für den Fall, dass die beiden Phasenverzögerungselemente 4,5 je eine schnelle Achse aufweisen, welche unter 90° zueinander orientiert sind.

Für ausreichend kleine Werte von $\Delta\Phi$, $\delta_1$ und $\delta_2$ lässt sich Gleichung (3) in guter Näherung schreiben als

$$\Delta\Phi'_S \approx \Delta\Phi_S\ [1 - (1/2)\delta_1\ \delta_2] \qquad (6)$$

Sind die schnellen Achsen der zwei Phasenverzögerungselemente 4,5 parallel zueinander ausgerichtet, so ergibt sich an Stelle der Gleichung (6)

$$\Delta\Phi'_S \approx \Delta\Phi_S\ [1 + (1/2)\delta_1\ \delta_2] \qquad (7)$$

Stehen die schnellen Achsen unter einem Winkel von 45° zueinander, so ergibt sich

$$\Delta\Phi'_S \approx \Delta\Phi_S\ [1 - (1/2)(\delta_1\delta_2/2)^2] \qquad (8)$$

Die Sensitivität des Stromsensors, das heisst sein normierter Skalenfaktor SK, ist dabei durch das Verhältnis $\Delta\Phi'_S/\Delta\Phi_S$ beschrieben.

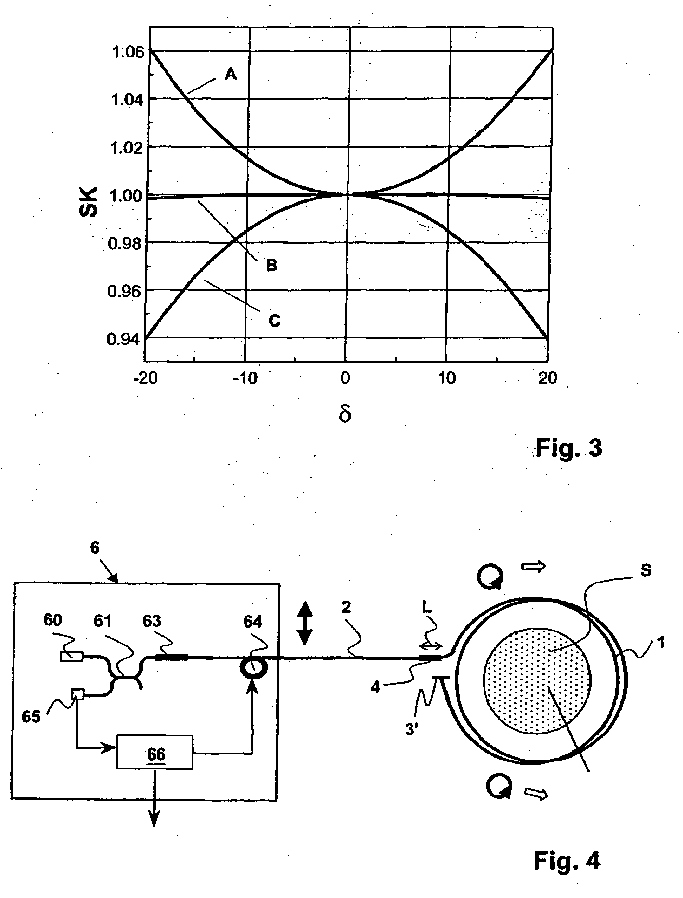

In Figur 3 ist der Skalenfaktor SK für die drei obengenannten verschiedene Ausrichtungen der schnellen Achsen als Funktion von $\delta$ dargestellt. $\delta$ ist dabei die Abweichung des Phasenverzögerungswinkels $\varphi$ vom Phasenverzögerungswinkel eines idealen $\lambda/4$-Segmentes, hier also von 90°. Im hier dargestellten Beispiel weisen das erste und zweite Phasenverzögerungselement 3,4 dieselbe Abweichung $\delta = \delta_1 = \delta_2$ auf. Die mit A bezeichnete Kurve stellt den Skalenfaktor für parallel zueinander ausgerichtete schnelle Achsen der zwei Phasenverzögerungselemente 3,4 dar. Die mit B bezeichnete Kurve zeigt den Skalenfaktor eines Stromsensors mit zwei Phasenverzögerungselementen, deren schnelle Achsen einen 45° Winkel bilden und bei der Kurve C sind die schnellen Achsen orthogonal zueinander ausgerichtet. Die Kurve B zeigt eine Abhängigkeit von $\delta$ in der 4. Potenz, wohingegen die Kurven A und C quadratische Abhängigkeiten darstellen.

Gemäss Figur 3 wird der Beitrag der $\lambda/4$-Segmente zur Temperaturabhängigkeit des Skalenfaktors um so grösser, je mehr die Phasenverzögerung von 90° abweicht. Für $\lambda/4$-Segmente höherer Ordnung wächst dabei die Temperaturabhängigkeit proportional zur Ordnung. Durch entsprechende Wahl des Phasenverzögerungswinkels bei der Herstellung der Phasenverzögerungselemente 4,5 lässt sich ihr Beitrag zur Temperaturabhängigkeit des Skalenfaktors SK gezielt beeinflussen.

Dabei ist die Art des Phasenverzögerungselementes zu berücksichtigen. Werden optische Fasern verwendet, so hängt deren Temperaturabhängigkeit stark vom Typ der Faser ab. Fasern mit stressinduzierter Doppelbrechung, wie eine Panda-Faser oder eine Bow-Tie-Faser, haben eine deutlich höhere Temperaturabhängigkeit als Fasern mit einem elliptischen Kernquerschnitt, welche eine geometrie bedingte Doppelbrechung aufweisen. Zudem wird der Phasenverzögerungswinkel in Abhängigkeit des Vorzeichens der Temperaturabhängigkeit gewählt.

Im hier dargestellten Beispiel soll eine Temperaturkompensation im Bereich von -40°C bis +80°C erreicht werden. Wie bereits erwähnt, beträgt der Beitrag der Verdet-Konstante V zur Temperturabhängigkeit des Stromssensors $0.7 \times 10^{-4}$/°C. d.h. zwischen -40°C und +80°C erhöht sich das Sensorsignal bei konstantem Strom aufgrund dieses Beitrags um 0.84%. Der Beitrag der zwei Phasenverzögerungselemente 4,5 sollte demnach das Signal über diesen Temperaturbereich um 0.84% erniedrigen. Dabei ist der Typ der Phasenverzögerungselemente und die gegenseitige Ausrichtung ihrer schnellen Achsen zu berücksichtigen.

1. Beispiel:

In einem ersten Beispiel eines Stromsensors gemäss Figur 1 beträgt die Temperaturabhängigkeit der Phasenverzögerung -0.0153° /°C, wie dies für ein λ/4-Segment aus einer kommerziellen Quarzglas-Faser mit einem elliptischen Kern typisch ist. Ferner sind die schnellen Achsen der λ/4-Segmente mindestens annähernd parallel orientiert. Eine optimale Temperaturkompensation des Sensors ist erreicht, wenn der Phasenverzögerungswinkel der λ/4-Segmente bei Raumtemperatur (20°C) statt auf 90° auf mindestens annähernd 105° eingestellt ist, wie dies in Figur 2 dargestellt ist. Bei einer Wellenlänge von 820 nm beträgt die Länge des faseroptischen Phasenverzögerungssegmentes deshalb 1.11 mm. Ein ideales λ/4-Segment würde eine Länge von 0.95 mm aufweisen. Der normierte Skalenfaktor SK erhöht sich von 1 auf 1.035.

2. Beispiel:

In einem zweiten Beispiel sind die schnellen Achsen der λ/4-Segmente nicht parallel, sondern mindestens annähernd orthogonal orientiert. Eine optimale Temperaturkompensation ist dann erreicht, wenn der Phasenverzögerungswinkel auf mindestens annähernd 75° einstellt ist. Die Länge des faseroptischen Phasenverzögerungssegmentes beträgt 0.79 mm. Der normierte Skalenfaktor SK vermindert sich auf 0.965.

Bei nicht parallelen oder orthogonalen Achsen der λ/4-Segmente ist eine Temperaturkompensation ebenfalls möglich, wenn die relative Achsenausrichtung bekannt ist. Der Zusammenhang zwischen $\Delta\Phi'_S$ und $\delta$ muss dazu mit Hilfe des Formalismus der Jones-Matrizen entsprechend berechnet werden. Mit zunehmender Abweichung von der orthogonalen bzw. parallelen Achsenorientierung muss jedoch, wie es aus Abb. 2 offensichtlich ist, im Vergleich zu einer Konfiguration mit orthogonalen oder parallelen Achsen eine grössere Abweichung der Phasenverzögerung von 90° gewählt werden, um eine möglichst vollständige Temperaturkompensation zu erreichen.

Verwendet man Phasenverzögerer mit grösserer Temperaturabhängigkeit (z. B. Fasersegmente mit stress-induzierter Doppelbrechung), so ist für die Temperaturkompensation eine entsprechend kleinere Abweichung der Phasenverzögerungen von 90° zu wählen.

Grundsätzlich lassen sich auch zwei λ/4-Segmente mit unterschiedlichen Phasenverzögerungen und Temperaturabhängigkeiten einsetzen, solange ihre kombinierte Wirkung die Temperaturabhängigkeit der Verdet-Konstante ausgleicht.

Ferner lassen sich anstelle der oben beschriebenen λ/4-Segmente auch λ/4-Platten als Phasenverzögerungselemente einsetzen, wobei die Temperaturkompensation durch Wahl der geeigneten Dicke der Platten erfolgt.

In Figur 4 ist ein faseroptischer Stromsensor mit einem Reflexions-Interferometer dargestellt. Im Gegensatz zum oben beschriebenen Sagnac-Interferometer, verfügt dieser Stromsensor nicht über eine Rückleitungsfaser, sondern ein der Zuleitungsfaser 3 abgewandtes Ende der Sensorfaser 1 ist als Reflektor 3' ausgebildet. Diese Konfiguration bildet, was die Temperaturkompensation anbelangt, einen Spezialfall des Stromsensors gemäss Figur 1. Bei einer Abweichung $\delta$ der Phasenverzögerung $\varphi$ des λ/4 Segmentes von 90° verhält sich das Reflexions-Interferometer wie ein Sagnac-Interferometer mit zwei identischen λ/4 Segmenten, deren Achsen parallel ausgerichtet sind. Die strominduzierte differentielle Phasenverschiebung beträgt dann näherungsweise

$$\Delta\Phi'_R \simeq \Delta\Phi_R \, (1 + \delta^2/2) \qquad (9).$$

$\Delta\Phi_R$ ist durch Gl. (2) gegeben. Beträgt die Temperaturabhängigkeit der Phasenverzögerung des λ/4-Segmentes wie im obigen Beispiel -0.0153° /°C, so ist der Phasenverzögerungswinkel bei Raumtemperatur auf 105° einzustellen und die Länge L des Segmentes entsprechend zu wählen, um eine Kompensation der Temperaturabhängigkeit der Verdet-Konstanten V zu erreichen.

Das Reflexions-Interferometer hat den Vorteil, dass bei bekannter Temperaturabhängigkeit des λ/4-Segmentes lediglich die Phasenverzögerung (d.h. die Länge des Segmentes) bei einer gegebenen Temperatur (i.a. Raumtemperatur) richtig gewählt werden muss, um eine Temperaturkompensation zu erreichen.

**EP 1 115 000 B1**

**Bezugzeichenliste**

| | |
|---|---|
| s | Stromleiter |
| L | Länge des Phasenverzögerungselementes |
| A | parallele schnelle Achsen |
| B | schnelle Achsen unter 45° |
| c | orthogonale schnelle Achsen |
| TW | Temperaturabhängigkeit des Phasenwinkels |
| TV | Temperaturabhängigkeit der Verdet-Konstanten |
| K | Temperaturkompensierter Stromsensor |
| φ | Phasenverzögerungswinkel |

| | |
|---|---|
| 1 | Sensorfaser |
| 2 | Zuleitungsfaser |
| 3 | Rückleitungsfaser |
| 3' | Reflektor |
| 4 | erstes Phasenverzögerungselement |
| 5 | zweites Phasenverzögerungselement |
| 6 | Auswertungsmodul |
| 60 | Laserdiode |
| 61 | erster Faserkoppler |
| 62 | zweiter Faserkoppler |
| 63 | Faserpolarisator |
| 64 | Phasenmodulator |
| 65 | Photodiode |
| 66 | Signalprozessor |

**Patentansprüche**

1. Faseroptischer Stromsensor mit einer spulenförmigen Sensorfaser (1), welche einen Stromleiter (S) umschliesst, **dadurch gekennzeichnet, dass** der Stromsensor mindestens ein Phasenverzögerungselement (4, 5) aufweist, welches zwischen der Sensorfaser (1) und einer Zu- bzw. Rückleitungsfaser (2, 3) angeordnet ist und welches optische Hauptachsen aufweist, die unter einem definierten Auslenkungswinkel zu den Hauptachsen der Zu- und Rückleitungsfasern (2, 3) ausgerichtet sind und dessen Länge zumindest näherungsweise so gewählt ist, dass es als $\lambda/4$-Phasenverzögerungselement wirkt, wobei die Zu- und Rückleitungsfaser (2, 3) mit einem gyroskopischen Modul (6) verbunden sind und der Stromsensor interferometrisch betrieben wird, wobei ferner das mindestens eine Phasenverzögerungselement (4, 5) einen Phasenverzögerüngswinkel φ aufweist, der durch Wahl der Länge des Phasenverzögerungselements (4, 5) abweichend von 90° gewählt ist und der eine Temperaturabhängigkeit aufweist derart, dass eine Temperaturabhängigkeit einer Verdet-Konstanten (V) der Sensorfaser (1) mindestens annähernd kompensiert ist.

2. Stromsensor nach Anspruch 1, **dadurch gekennzeichnet, dass** der definierte Auslenkungswinkel 45° beträgt.

3. Stromsensor nach Anspruch 1, **dadurch gekennzeichnet, dass** das mindestens eine Phasenverzögerungselement (4, 5) ein $\lambda/4$-Fasersegment mit einem elliptischen Kern ist und dass das $\lambda/4$-Fasersegment eine Länge (L) aufweist, welche von Viertel oder einem ungeradzahligen Vielfachen eines Viertels einer Schwebungsslänge von orthogonalen Polarisationsmoden abweicht.

4. Stromsensor nach Anspruch 1, **dadurch gekennzeichnet, dass** die Grösse des Phasenverzögerungswinkels in Abhängigkeit einer gegenseitigen Ausrichtung von schnellen Achsen der Phasenverzögerungselemente (4, 5) gewählt ist.

5. Stromsensor nach Anspruch 1, **dadurch gekennzeichnet, dass** die Grösse des Phasenverzögerungswinkels in Abhängigkeit eines Vorzeichens der Temperaturabhängigkeit des mindestens einen Phasenverzögerungselementes (4, 5) gewählt ist.

7

**6.** Stromsensor nach den Ansprüchen 1, 4 und 5, **dadurch gekennzeichnet, dass** mindestens zwei Phasenvemögerungselemente (4, 5) mit je einer schnellen Achse vorhanden sind; wobei die Verbindung der Zu- bzw. Rückleitungsfaser (2, 3) mit der Sensorfaser (1) über mindestens je eines der Phasenverzögerungselemente (4, 5) erfolgt, wobei ferner die schnellen Achsen mindestens annähernd parallel zueinander orientiert sind, und dass der Phasenverzögerungswinkel φ bei einer Temperaturabhängigkeit der Phasenverzögerungselemente (4, 5) mit negativem Vorzeichen grösser und bei einer Temperaturabhängigkeit mit positivem Vorzeichen kleiner als ein Phasenverzögerungswinkel eines idealen λ/4-Phasenverzögerungselementes ist.

**7.** Stromsensor nach den Ansprüchen 1, 4 und 5, **dadurch gekennzeichnet, dass** mindestens zwei Phasenverzögerungselemente (4, 5) mit je einer schnellen Achse vorhanden sind, wobei die Verbindung der Zu- bzw. Rückleitungsfaser (2, 3) mit der Sensorfaser (1) über mindestens je eines der Phasenverzögerungselemente (4, 5) erfolgt, wobei ferner die schnellen Achsen mindestens annähernd orthogonal zueinander orientiert sind, und dass der Phasenverzögerungswinkel φ bei einer Temperaturabhängigkeit der Phasenverzögerungselemente (4, 5) mit negativem Vorzeichen kleiner und bei einer Temperaturabhängigkeit mit positivem Vorzeichen grösser als ein Phasenverzögerunpwinkel eines idealen λ/4-Phasenverzögerungselementes ist.

**8.** Stromsensor nach Anspruch 1, **dadurch gekennzeichnet, dass** er ein Sagnac-Interferometer aufweist.

**9.** Stromsensor nach Anspruch 1, **dadurch gekennzeichnet, dass** er ein Reflexions- Interferometer aufweist.

**Claims**

**1.** Fibre optic current sensor having a coiled sensor fibre (1) which encloses a current conductor (S), **characterized in that** the current sensor has at least one phase delay element (4, 5) which is arranged between the sensor fibre (1) and a feed or return fibre (2, 3), and which has optical main axes which are aligned at a deflection angle relative to the main axes of the feed and return fibres (2, 3), and whose length is selected at least approximately such that it acts as a λ/4 phase delay element, in which the feed and return fibres (2, 3) are connected to a gyroscopic module (6) and the current sensor is operated interferometrically, and in which the at least one phase delay element (4, 5) has a phase delay angle φ which is selected in a fashion deviating from 90° by selecting the length of the phase delay element (4, 5), and which has a temperature dependence in such a way that a temperature dependence of a Verdet's constant (V) of the sensor fibre (1) is at least approximately compensated.

**2.** Current sensor according to Claim 1, **characterized in that** the defined deflection angle is 45°.

**3.** Current sensor according to Claim 1, **characterized in that** the at least one phase delay element (4, 5) is a λ/4 fibre segment with an elliptical core, and **in that** the λ/4 fibre segment has a length (L) which deviates from a quarter or an odd multiple of a quarter of a beat length of orthogonal polarization modes.

**4.** Current sensor according to Claim 1, **characterized in that** the magnitude of the phase delay angle is selected as a function of a mutual alignment of fast axes of the phase delay element (4, 5).

**5.** Current sensor according to Claim 1, **characterized in that** the magnitude of the phase delay angle is selected as a function of a sign of the temperature dependence of the at least one phase delay element (4, 5).

**6.** Current sensor according to Claims 1, 4 and 5, **characterized in that** there are at least two phase delay elements (4, 5), each having a fast axis, the feed or return fibre (2, 3) being connected to the sensor fibre (1) via at least one of the phase delay elements (4, 5) in each case, the fast axes furthermore being orientated at least approximately parallel to one another, and **in that** in the case of a temperature dependence of the phase delay elements (4, 5) of negative sign the phase delay angle φ is greater, and in the case of a temperature dependence of positive sign it is smaller than a phase delay angle of an ideal λ/4 phase delay element.

**7.** Current sensor according to Claims 1, 4 and 5, **characterized in that** there are at least two phase delay elements (4, 5) each having a fast axis, the feed or return fibre (2, 3) being connected to the sensor fibre (1) via at least one of the phase delay elements (4, 5) in each case, the fast axes furthermore being orientated at least approximately orthogonally to one another, and **in that** in the case of a temperature dependence of the phase delay elements (4, 5) of negative sign the phase delay angle φ is smaller, and in the case of a temperature dependence of positive sign it is larger than a phase delay angle of an ideal λ/4 phase delay element.

**8.** Current sensor according to Claim 1, **characterized in that** it has a Sagnac interferometer.

**9.** Current sensor according to Claim 1, **characterized in that** it has a reflection interferometer.

**Revendications**

**1.** Détecteur de courant optique à fibres comprenant une fibre de détection (1) en forme de bobine qui renferme un conducteur électrique (S), **caractérisé en ce que** le détecteur de courant présente au moins un élément de retard de phase (4, 5) qui est disposé entre la fibre de détection (1) et une fibre d'aller ou de retour (2, 3) et qui présente des axes optiques principaux, lesquels sont dirigés sous un angle de déviation défini par rapport aux axes principaux des fibres d'aller et de retour (2, 3) et dont la longueur est au moins approximativement choisie de telle sorte qu'il fait office d'élément de retard de phase λ/4, les fibres d'aller et de retour (2, 3) étant reliées avec un module gyroscopique (6) et le détecteur de courant fonctionnant par interférométrie, l'au moins un élément de retard de phase (4, 5) présentant en outre un angle de retard de phase φ qui est choisi différent de 90° par le choix de la longueur de l'élément de retard de phase (4, 5) et qui présente une dépendance à la température telle qu'une dépendance à la température d'une constante de Verdet (V) de la fibre de détection (1) est compensée au moins approximativement.

**2.** Détecteur de courant selon la revendication 1, **caractérisé en ce que** l'angle de déviation défini est égal à 45°.

**3.** Détecteur de courant selon la revendication 1, **caractérisé en ce que** l'au moins un élément de retard de phase (4, 5) est un segment de fibre λ/4 ayant un noyau elliptique et que le segment de fibre λ/4 présente une longueur (L) qui est différente d'un quart ou d'un multiple impair d'un quart de la longueur de battement des modes de polarisation orthogonaux.

**4.** Détecteur de courant selon la revendication 1, **caractérisé en ce que** la valeur de l'angle de retard de phase est choisie en fonction d'un alignement réciproque des axes rapides des éléments de retard de phase (4, 5).

**5.** Détecteur de courant selon la revendication 1, **caractérisé en ce que** la valeur de l'angle de retard de phase est choisie en fonction d'un signe de la dépendance à la température de l'au moins un élément de retard de phase (4, 5).

**6.** Détecteur de courant selon les revendications 1, 4 et 5, **caractérisé en ce qu'**il existe au moins deux éléments de retard de phase (4, 5) comprenant chacun un axe rapide, la liaison de la fibre d'aller ou de retour (2, 3) avec la fibre de détection (1) s'effectuant à chaque fois par le biais d'au moins l'un des éléments de retard de phase (4, 5), les axes rapides étant en outre orientés au moins approximativement parallèlement l'un à l'autre et que l'angle de retard de phase φ, dans le cas d'une dépendance à la température des éléments de retard de phase (4, 5) avec un signe négatif, est supérieur à un angle de retard de phase d'un élément de retard de phase λ/4 idéal et inférieur à celui-ci dans le cas d'une dépendance à la température des éléments de retard de phase avec un signe positif.

**7.** Détecteur de courant selon les revendications 1, 4 et 5, **caractérisé en ce qu'**il existe au moins deux éléments de retard de phase (4, 5) comprenant chacun un axe rapide, la liaison de la fibre d'aller ou de retour (2, 3) avec la fibre de détection (1) s'effectuant à chaque fois par le biais d'au moins l'un des éléments de retard de phase (4, 5), les axes rapides étant en outre orientés au moins approximativement orthogonalement l'un à l'autre et que l'angle de retard de phase φ, dans le cas d'une dépendance à la température des éléments de retard de phase (4, 5) avec un signe négatif, est inférieur à un angle de retard de phase d'un élément de retard de phase λ/4 idéal et supérieur à celui-ci dans le cas d'une dépendance à la température des éléments de retard de phase avec un signe positif.

**8.** Détecteur de courant selon la revendication 1, **caractérisé en ce qu'**il présente un interféromètre de Sagnac.

**9.** Détecteur de courant selon la revendication 1, **caractérisé en ce qu'**il présente un interféromètre à réflexion.

**Fig. 1**

**Fig. 2**

**Fig. 3**

**Fig. 4**